# EUROPÄISCHE PATENTSCHRIFT

(11) **EP 3 313 604 B1**
(45) Veröffentlichungstag und Bekanntmachung des Hinweises auf die Patenterteilung: **15.01.2020**
(21) Anmeldenummer: 16732274.2
(22) Anmeldetag: 23.06.2016
(51) Int. Cl.: B23K 26/00, B28D 1/00, B28D 1/22, B28D 5/00, C03B 33/02, C03B 33/09, C03B 33/095, H01L 21/268, H01L 21/304, B23K 26/53, B23K 101/40

(54) **VERFAHREN ZUM FÜHREN EINES RISSES IM RANDBEREICH EINES SPENDERSUBSTRATS MIT EINEM GENEIGTEN LASERSTRAHL**
METHOD FOR MAKING A CRACK IN THE EDGE PORTION OF A DONOR SUBSTRATE, USING AN INCLINED LASER BEAM
PROCÉDÉ POUR GUIDER LE CHEMINEMENT D'UNE FISSURE DANS LA ZONE MARGINALE D'UN SUBSTRAT DONNEUR AU MOYEN D'UN FAISCEAU LASER INCLINÉ

(30) Priorität: 23.06.2015 DE 102015008034
(43) Veröffentlichungstag der Anmeldung: 02.05.2018
(73) Patentinhaber: Siltectra GmbH, 01099 Dresden (DE)
(72) Erfinder: SWOBODA, Marko, 01097 Dresden (DE); BEYER, Christian, 09599 Freiberg (DE); SCHILLING, Franz, 01454 Radeberg (DE); RICHTER, Jan, 01109 Dresden (DE)
(74) Vertreter: Müller Hoffmann & Partner
(86) Internationale Anmeldenummer: PCT/EP2016/064536
(87) Internationale Veröffentlichungsnummer: WO 2016/207277

(56) Entgegenhaltungen:
- DE-A1-102014 014 486
- JP-A- 2008 201 143
- US-A1- 2015 159 279

## Beschreibung

Die vorliegende Erfindung bezieht sich auf ein Verfahren zum Abtrennen von Festkörperscheiben von einem Spendersubstrat gemäß dem Oberbegriff des Anspruchs 1 (siehe, z.B., JP 2008/201143 A).

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustem die Bereiche mit den größten Schwankungen unglücklicherweise in der Mitte des Wafers, wo sie am meisten stören. Besonders kritisch ist hierbei die Rissführung, da nur bei einer sehr präzisen Rissführung Festkörperscheiben mit einem geringen TTV unmittelbar erzeugbar sind.

Es wurde erkannt, dass mittels LASER-Strahlen zwar Modifikationen zum Vorgeben eines Rissverlaufs beabstandet zum Rand des Festkörpers in einem Festkörper erzeugbar sind, dies jedoch im Bereich des Rands eines Festkörpers aufgrund von Randeffekten nicht ohne weiteres möglich ist. Trifft der Laserfokus mit seiner Mitte direkt die Kante des Materials, so ist trifft eine Hälfte des Strahls mit finiter Ausdehnung den Festkörper, die andere Hälfte läuft in der Luft. Aufgrund des Unterschieds im Brechindex führt dies zu einer Schädigung an der Seite des Festkörpers, weit oberhalb der eigentlich intendierten Schadschicht nach Brechindexkorrektur. Da außerdem nur die Hälfte oder ein Bruchteil der Laserstrahlung ins Material gekoppelt wird, ist die Schädigung am Rand gegenüber der Mitte des Festkörpers reduziert. Diese verminderte Schädigung führt dazu, dass der Riss beim Verlauf am Rand Verwerfungen zeigt oder nicht in der Laserebene verläuft.

Es ist somit die Aufgabe der vorliegenden Erfindung ein Verfahren bereit zu stellen, das die Herstellung von Wafern mit einem geringen TTV ermöglicht.

Die zuvor genannte Aufgabe wird erfindungsgemäß durch ein Verfahren zum Abtrennen von Festkörperscheiben von einem Spendersubstrat gemäß Anspruch 1 gelöst. Das erfindungsgemäße Verfahren umfasst dabei mindestens die Schritte: Bereitstellen eines Spendersubstrats,

Erzeugen von mindestens einer Modifikationen im Inneren des Spendersubstrats mittels mindestens eines LASER-Strahls, wobei der LASER-Strahl über eine ebene Oberfläche des Spendersubstrats in das Spendersubstrat eindringt,
wobei der LASER-Strahl derart gegenüber der ebenen Oberfläche des Spendersubstrats geneigt ist, dass er in einem Winkel von ungleich 0° oder 180° gegenüber der Längsachse des Spendersubstrates in das Spendersubstrat eindringt, wobei der LASER-Strahl zum Erzeugen der Modifikation im Spendersubstrat fokussiert wird, wobei sich die Festkörperscheibe durch die erzeugten Modifikationen von dem Spendersubstrat ablöst oder eine Spannungserzeugungsschicht an der ebenen Oberfläche des Spendersubstrats erzeugt oder angeordnet wird und durch ein thermisches Beaufschlagen der Spannungserzeugungsschicht mechanische Spannungen in dem Spendersubstrat erzeugt werden, wobei durch die mechanischen Spannungen ein Riss zum Abtrennen einer Festkörperschicht entsteht, der sich entlang der Modifikationen ausbreitet. Bevorzugt dringt ein erster Anteil des LASER-Strahls in einem ersten Winkel zur ebenen Oberfläche des Spendersubstrats in das Spendersubstrat eindringt und mindestens ein weiterer Anteil des LASER-Strahls in einem zweiten Winkel zur eben Oberfläche des Spendersubstrats in das Spendersubstrat ein, wobei sich der Betrag des ersten Winkels von dem Betrag des zweiten Winkels unterscheidet, wobei der erste Anteil des LASER-Strahls und der weitere Anteil des LASER-Strahls zum Erzeugen der Modifikation im Spendersubstrat fokussiert werden.

Bevorzugt wird der Spenderwafer und/oder die die LASER-Strahlen emittierende LASER-Einrichtung während der Erzeugung der Modifikationen um eine Rotationsachse rotiert. Besonders bevorzugt erfolgt zusätzlich oder alternativ zur Rotation des Spenderwafers eine Veränderung des Abstandes der LASER-Strahlen zum Zentrum des Spenderwafers.

Die Gesamtheit der LASER-Strahlen ist gemäß einer weiteren bevorzugten Ausführungsform der vorliegenden Erfindung für die Erzeugung von Modifikationen im Bereich des Zentrums des Spendersubstrats und für die Erzeugung von Modifikationen im Bereich eines sich in radialer Richtung ergebenden Rands des Spendersubstrats in derselben Ausrichtung gegenüber der ebenen Oberfläche des Spendersubstrats ausgerichtet.

Diese Lösung ist vorteilhaft, da der gesamte Querschnitt des Laserstrahls beim Eintritt in den Festkörper eine ebene Fläche trifft, da dann in der Tiefe eine homogene Schädigung auftritt. Diese homogene Schädigung ist bis an den äußeren, insbesondere sich orthogonal zur ebenen Oberfläche erstreckenden, Rand des Spendersubstrats erzeugbar. Somit können die Modifikationen um Randbereich des Spendersubstrats und im Bereich des Zentrums des Spendersubstrats mittels eines Bearbeitungsschritts erzeugt werden.

Der erste Anteil der LASER-Strahlen dringt gemäß der Erfindung in einem ersten Winkel zur Oberfläche des Spendersubstrats in das Spendersubstrat ein und der weitere Anteil der LASER-Strahlen dringt in einem zweiten Winkel für die Erzeugung von Modifikationen im Bereich des Zentrums des Spendersubstrats und für die Erzeugung von Modifikationen im Bereich eines sich in radialer Richtung ergebenden Rands des Spendersubstrats ein, wobei sich der Betrag des ersten Winkels von dem Betrag des zweiten Winkels stets unterscheidet. Bevorzugt sind der erste Winkel und der zweite Winkel während der Erzeugung der Modifikationen konstant bzw. unverändert bzw. werden nicht verändert.

Weitere bevorzugte Ausführungsformen sind Gegenstand der Unteransprüche und/oder der nachfolgenden Beschreibungsteile.

Die Vertiefung umgibt das Spendersubstrat gemäß einer weiteren bevorzugten Ausführungsform der vorliegenden Erfindung vollständig in Umfangsrichtung. Diese Ausführungsform ist vorteilhaft, da der Riss über den gesamten Umfang des Spendersubstrats definiert in das Spendersubstrat einleitbar ist.

Die Vertiefung verläuft gemäß einer weiteren bevorzugten Ausführungsform der vorliegenden Erfindung in Richtung Zentrum bis zu einem Vertiefungsende hin enger werdend, insbesondere keil- oder kerbförmig, wobei das Vertiefungsende in der Ebene liegt, in der sich der Riss ausbreitet. Diese Ausführungsform ist vorteilhaft, da durch das Vertiefungsende eine Kerbe schaffen wird, durch welche die Ausbreitrichtung des Risses vorgegeben wird.

Die asymmetrische Vertiefung wird gemäß einer weiteren bevorzugten Ausführungsform der vorliegenden Erfindung mittels eines zur Vertiefung zumindest abschnittsweise negativ geformten Schleifwerkzeugs erzeugt. Diese Ausführungsform ist vorteilhaft, das Schleifwerkzeug gemäß der zu erzeugenden Kante bzw. Vertiefung herstellbar ist.

Das Schleifwerkzeug weist gemäß einer weiteren bevorzugten Ausführungsform der vorliegenden Erfindung mindestens zwei verschieden geformte Bearbeitungsanteile auf, wobei ein erster Bearbeitungsanteil zum Bearbeiten des Spendersubstrats im Bereich der Unterseite einer abzutrennenden Festkörperscheibe und ein zweiter Bearbeitungsanteil zum Bearbeiten des Spendersubstrats im Bereich der Oberseite der von dem Spendersubstrat abzutrennenden Festkörperscheibe bestimmt ist. Diese Ausführungsform ist vorteilhaft, da mittels des Schleifwerkzeugs neben Umformungen zum Bewirken einer verbesserten Rissführung ebenfalls Umformungen zur besseren Handhabung zeitgleich oder zeitversetzt an dem Spendersubstart bzw. an den eine oder mehrere Festkörperscheibe/n ausbildenden Anteilen des Spendersubstrats bewirkt werden können.

Gemäß einer weiteren bevorzugten Ausführungsform der vorliegenden Erfindung erzeugt der erste Bearbeitungsanteil eine tiefere oder volumenmäßig größere Vertiefung in dem Spendersubstrat als der zweite Bearbeitungsanteil, wobei der erste Bearbeitungsanteil und/oder der zweite Bearbeitungsanteil gebogene oder gerade Schleifflächen aufweisen. Bevorzugt weist der erste Bearbeitungsanteil eine gebogene Hauptschleiffläche auf und der zweite Bearbeitungsanteil weist bevorzugt ebenfalls eine gebogene Nebenschleiffläche auf, wobei der Radius der Hauptschleiffläche größer ist als der Radius der Nebenschleiffläche, bevorzugt ist der Radius der Hauptschleiffläche mindestens doppelt so groß wie der Radius der Nebenschleiffläche oder der erste Bearbeitungsanteil weist eine gerade Hauptschleiffläche auf und der zweite Bearbeitungsanteil weist eine gerade Nebenschleiffläche auf, wobei mittels der Hauptschleiffläche mehr Material als mit der Nebenschleiffläche von dem Spendersubstrat entfernt wird oder der erste Bearbeitungsanteil weist eine gerade Hauptschleiffläche auf und der zweite Bearbeitungsanteil weist eine gebogene Nebenschleiffläche auf oder der erste Bearbeitungsanteil weist eine gebogene Hauptschleiffläche auf und der zweite Bearbeitungsanteil weist eine gerade Nebenschleiffläche auf.

Bevorzugt weist das Schleifwerkezeug eine Vielzahl, insbesondere mehr als 2, 3, 4, 5, 6, 7, 8, 9 oder 10, an Bearbeitungsanteilen auf, um eine entsprechende Vielzahl an unterschiedlichen Festkörperscheiben zuordenbaren Anteile des Spendersubstrats spanend bzw. materialentfernend zu bearbeiten.

Gemäß einer weiteren bevorzugten Ausführungsform der vorliegenden Erfindung werden die Ablations-LASER-Strahlen mit einer Wellenlänge im Bereich zwischen 300 nm (UV-Ablation mit frequenzverdreifachtem Nd:YAG- oder anderem Festkörperlaser) und 10 µm (CO₂-Gaslaser, oft für Gravur und Schneidprozesse verwendet), mit einer Pulsdauer von weniger als 100 Mikrosekunden und bevorzugt von weniger als 1 Mikrosekunde und besonders bevorzugt von weniger als 1/10 Mikrosekunde und mit einer Pulsenergie von mehr als 1µJ und bevorzugt von mehr als 10 µJ erzeugt. Diese Ausführungsform ist vorteilhaft, da mittels einer LASER-Einrichtung und nicht mittels eines sich abnutzenden Schleifwerkezeugs die Vertiefung erzeugbar ist.

Die Modifikationen im Spendersubstrat werden materialabhängig bevorzugt mit den nachfolgend angeführten Konfigurationen bzw. LASER-Parametern erzeugt: Besteht das Spendersubstrat aus Silizium oder weist das Spendersubstart Silizium auf, so werden bevorzugt Nanosekundenpulse oder kürzer(<500ns), eine Pulsenergie im Mikrojoulebereich (<100µJ) und eine Wellenlänge >1000nm verwendet.

Bei allen anderen Materialien und Materialkombinationen werden bevorzugt Pulse <5 Pikosekunden, Pulsenergien im Mikrojoulebereich (<100µJ) und Wellenlängen Wellenlängen variabel zwischen 300nm und 2500nm verwendet.

Wichtig ist hierbei, dass eine große Apertur vorgesehen wird, um tief ins Material zu gelangen. Die Apertur zur Erzeugung der Modifikationen im Inneren des Spendersubstrats ist somit bevorzugt größer als die Apertur zur Ablation von Material mittels der Ablations-LASER-Strahlen zum Erzeugen der Vertiefung. Bevorzugt ist die Apertur mindestens um ein Vielfaches, insbesondere mindestens um das 2, 3, 4, 5, 6-fache größer als die Apertur zur Ablation von Material mittels der Ablations-LASER-Strahlen zum Erzeugen der Vertiefung. Die Fokusgröße zur Erzeugung einer Modifikation ist, insbesondere hinsichtlich ihres Durchmessers, bevorzugt kleiner als 10µm, bevorzugt kleiner als 5µm und besonders bevorzugt kleiner als 3µm.

Die LASER-Einrichtung umfasst gemäß einer weiteren bevorzugten Ausführungsform der vorliegenden Erfindung einen Femtosekunden-LASER (fs-LASER) oder einen Picosekunden-LASER (ps-LASER) und die Energie der LASER-Strahlen des LASER (fs-LASER oder ps-LASER) wird bevorzugt derart gewählt, dass die Schädigungsausbreitung einer jeden Modifikation in der Nutzschicht und/oder der Opferschicht kleiner als 3 mal die Rayleighlänge, bevorzugt kleiner als die Rayleighlänge und besonders bevorzugt kleiner ein Drittel mal die Rayleighlänge ist und/oder die Wellenlänge der LASER-Strahlen des fs-LASER wird derart gewählt, dass die Absorption der Nutzschicht und/oder der Opferschicht kleiner als 10cm⁻¹ und bevorzugt kleiner als 1cm⁻¹ und besonders bevorzugt kleiner als 0.1cm⁻¹ ist und/oder die einzelnen Modifikationen ergeben sich jeweils in Folge einer von dem fs-LASER bewirkten multi-photonen Anregung.

Gemäß der Erfindung dringen die LASER-Strahlen zum Erzeugen der Modifikationen über eine Oberfläche in den Spenderwafer ein, die Bestandteil der abzutrennenden Festkörperscheibe ist. Diese Ausführungsform ist vorteilhaft, da eine geringere Aufheizung des Spendersubstrats erfolgt, wodurch dieses nur geringen thermischen Spannungen ausgesetzt wird.

Die Spannungserzeugungsschicht weist gemäß einer weiteren bevorzugten Ausführungsform der vorliegenden Erfindung ein Polymer, insbesondere Polydimethylsiloxan (PDMS), auf oder besteht daraus, wobei die thermische Beaufschlagung bevorzugt derart erfolgt, dass das Polymer einen Glasübergang erfährt, wobei die Spannungserzeugungsschicht, insbesondere mittels flüssigem Stickstoff, auf eine Temperatur unterhalb der Raumtemperatur (d.h. auf eine Temperatur von weniger als 20°C) oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht, temperiert wird.

Diese Ausführungsform ist vorteilhaft, da erkannt wurde, dass durch die thermische Beaufschlagung der Spannungserzeugungsschicht, insbesondere durch Ausnutzung der beim Glasübergang auftretenden Eigenschaftsveränderungen des Materials der Spannungserzeugungsschicht, die zur Rissauslösung und Rissführung erforderlichen Kräfte in einem Spendersubstrat erzeugt werden können.

Das Spendersubstrat weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN bzw. besteht aus einem oder mehreren dieser Materialien. Besonders bevorzugt weist das Spendersubstrat eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann das Spendersubstrat eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Biel-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Das Spendersubstrat weist somit bevorzugt ein Halbleitermaterial oder ein Keramikmaterial auf bzw. besonders bevorzugt besteht das Spendersubstrat aus mindestens einem Halbleitermaterial oder einem Keramikmaterial. Es ist weiterhin denkbar, dass das Spendersubstrat ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAlSb, Hochtemperatursupraleiter, insbesondere seltene Erden Cuprate (z.B. YBa2Cu3O7).

Die Gegenstände der Patentanmeldung DE 2013 205 720.2 mit dem Titel: "Verfahren zur Kantenverrundung von aus einem Halbleiter-Ausgangsmaterial erzeugten Halbleiter-Teilstücken und mittels dieses Verfahrens hergestellte Halbleiterprodukte" werden hiermit vollumfänglich durch Bezugnahme zum Gegenstand der vorliegenden Beschreibung gemacht.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, Insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft die erfindungsgemäßen Lösungen dargestellt sind. Bauteile oder Elemente oder Verfahrensschritte der erfindungsgemäßen Lösungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1: ein Beispiel für eine Randbehandlung im Rahmen der erfindungsgemäßen Festkörperscheibenherstellung bzw. Festkörperlagenherstellung,
- Fig. 2: eine Randbehandlung im Rahmen der Festkörperscheibenherstellung bzw. Festkörperlagenherstellung,
- Fig. 3: eine Darstellung, die Probleme zeigt, die beim Erzeugen von Modifikationen in einem Festkörper auftreten, wenn die Modifikationen mittels LASER-Strahlen erzeugt werden,
- Fig. 4: eine Darstellung, die verschiedene LASER-Strahlwinkel zeigt,
- Fig. 5a/5b: eine Darstellung, eines Modifikationserzeugungsschrittes und eine schematische Darstellung der erzeugten Modifikationen,
- Fig. 6a/6b: zwei Darstellungen von Modifikationserzeugungsschritten,
- Fig. 7: eine Modifikationserzeugung mit einer Aberrationsanpassung und

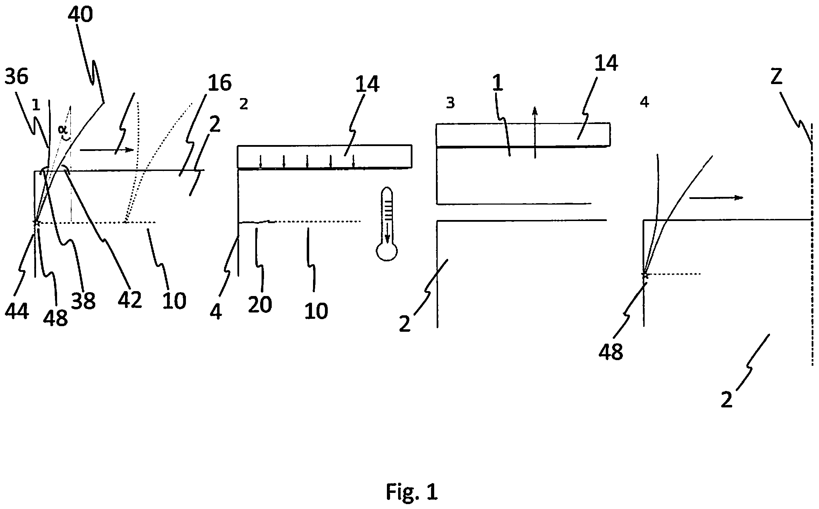

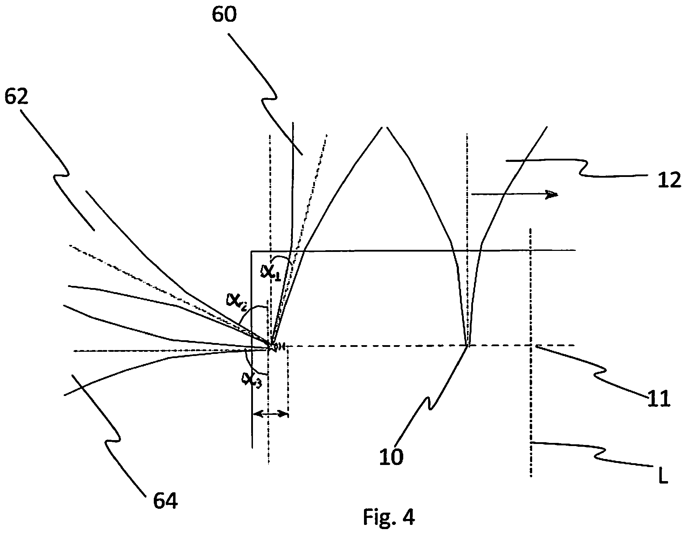

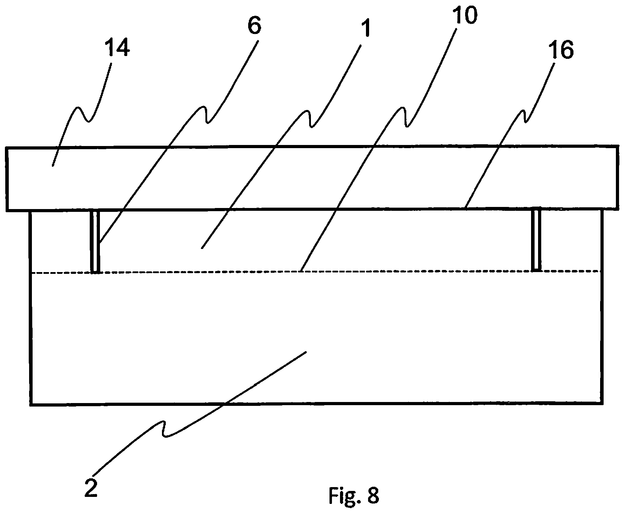

Fig. 8 eine schematische Darstellung eines Festkörpers, der Vertiefungen aufweist, die von einer Spannungserzeugungsschicht überdeckt bzw. überlagert bzw. verschlossen werden. Fig. 1 zeigt 4 Darstellungen. In der ersten Darstellung der Fig. 1 ist ein Spendersubstrat 2 gezeigt, dass mit LASER-Strahlen 12 beaufschlagt wird. Die LASER-Strahlen 12 sind in ihrer Gesamtheit derart gegenüber der Oberfläche 16, über die die LASER-Strahlen in das Spendersubstrat 2 eindringen, geneigt, dass die Neigung von einem 90° Winkel abweicht. Bevorzugt ist ein erster Anteil 36 an LASER-Strahlen 12 gegenüber der Oberfläche 16 in einem ersten Winkel 38 orientiert und ein weiterer Anteil 40 an LASER-Strahlen 12 ist gegenüber der Oberfläche 16 in einem zweiten Winkel 42 orientiert. Die LASER-Strahlanteile 36 und 40 sind bevorzugt zur Erzeugung aller zur Abtrennung einer bestimmten Festkörperschicht 1 erzeugten Modifikationen 12 gegenüber der Oberfläche 16, über die die LASER-Strahlenanteile 36, 40 in das Spendersubstrat 2 eindringen, bevorzugt stets identisch geneigt. Es kann der ersten Darstellung der Fig. 4 ferner entnommen werden, dass der Fokuspunkt 48 zum Erzeugen von Modifikationen 10 aufgrund der geneigten LASER-Strahlanteile 36, 40 in dem Spendersubstrat 2 bis zum Rand 44 oder unmittelbar bis zum Rand 44 geführt werden kann.

Der Darstellung 2 der Fig. 1 lässt sich ferner entnehmen, dass gemäß der geneigt ausgerichteten LASER-Strahlanteile 36, 40 eine materialabtragende Behandlung des Rands 44 des Spendersubstrats 2 nicht oder nur deutlich reduziert erforderlich ist. Die an der Oberfläche 16 angeordnete oder erzeugte Spannungserzeugungsschicht 14 bewirkt eine Erzeugung mechanischer Spannungen in dem Spendersubstrat 2, wodurch sich aufgrund der bis zum Rand 44 erzeugten Modifikationen 10 ein Riss 20 sehr präzise geführt vom Rand 44 in das Spendersubstrat 2 hineinausbreitet.

Der Darstellung 3 der Fig. 1 zeigt eine vollständig vom Spendersubstrat 2 abgespaltete Festkörperscheibe 1, wobei die Festkörperscheibe 1 gemäß dieser Ausführungsform bevorzugt keine Kantenbehandlung erfahren hat.

Darstellung 4 der Fig. 1 deutet an, dass ebenfalls durch das Erzeugen von Modifikationen 10 mittels LASER-Strahlen 36, 40 (ohne eine Spannungserzeugungsschicht 14) eine Festkörperscheibe 1 von dem Spendersubstrat 2 entfernbar ist.

Die vorliegende Erfindung bezieht sich somit auf ein Verfahren zum Abtrennen von Festkörperscheiben 1 von einem Spendersubstrat 2. Das erfindungsgemäße Verfahren umfasst dabei die Schritte:
Bereitstellen eines Spendersubstrats 2, Erzeugen von Modifikationen 10 im Inneren des Spendersubstrats 2 mittels LASER-Strahlen 12, wobei die LASER-Strahlen 12 über eine ebene Oberfläche 16 des Spendersubstrats 2 in das Spendersubstrat 2 eindringen, wobei die Gesamtheit der LASER-Strahlen 12 derart gegenüber der ebenen Oberfläche 16 des Spendersubstrats 2 geneigt ist, dass ein erster Anteil 36 der LASER-Strahlen 12 in einem ersten Winkel 38 zur ebenen Oberfläche 16 des Spendersubstrats 2 in das Spendersubstrat 2 eindringt und mindestens ein weiterer Anteil 40 der LASER-Strahlen 12 in einem zweiten Winkel 42 zur eben Oberfläche 16 des Spendersubstrats 2 in das Spendersubstrat 2 eindringt, wobei sich der Betrag des ersten Winkels 38 von dem Betrag des zweiten Winkels 42 unterscheidet, wobei der erste Anteil 36 der LASER-Strahlen 12 und der weitere Anteil 40 der LASER-Strahlen 12 zum Erzeugen der Modifikation 10 im Spendersubstrat 2 fokussiert werden, wobei sich die Festkörperscheibe 1 durch die erzeugten Modifikationen 10 von dem Spendersubstrat 2 ablöst oder eine Spannungserzeugungsschicht (14) an der ebenen Oberfläche (16) des Spendersubstrats (2) erzeugt oder angeordnet wird und durch ein thermisches Beaufschlagen der Spannungserzeugungsschicht (14) mechanische Spannungen in dem Spendersubstrat (2) erzeugt werden, wobei durch die mechanischen Spannungen ein Riss (20) zum Abtrennen einer Festkörperschicht (1) entsteht, der sich entlang der Modifikationen (10) ausbreitet.

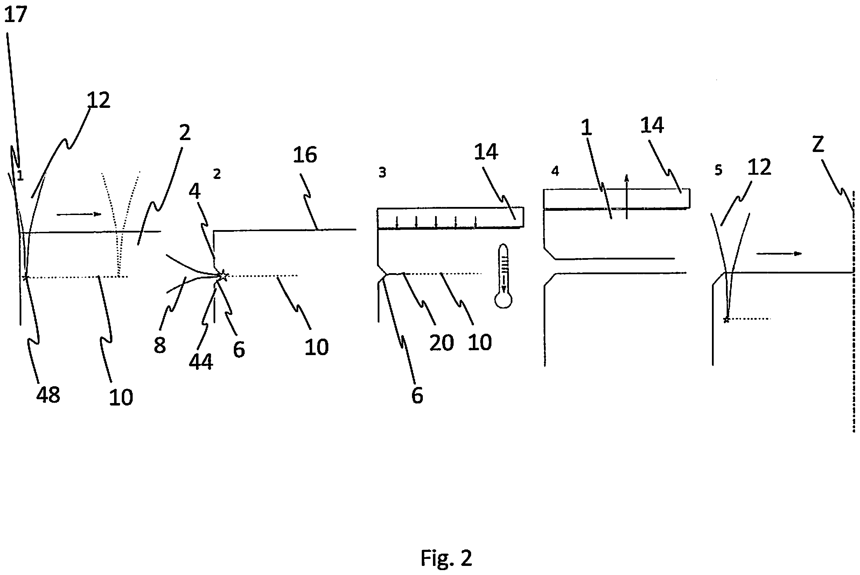

Fig. 2 zeigt ein anderes Verfahren, das nicht Teil der Erfindung darstellt. Es kann durch einen Vergleich der ersten und der fünften Darstellung erkannt werden, dass die mittels den LASER-Strahlen 12 erzeugten Modifikationen 10 im Falle einer ebenen Oberfläche 16 näher zum Rand 44 hin erzeugt werden können, als wenn die Kante 17 der Oberfläche 16 entfernt ist, wie dies in der fünften Darstellung gezeigt ist. Die LASER-Strahlen 12 dringen hierbei analog zur bzgl. Fig.1 erläuterten Modifikationserzeugung in das Spendersubstrat 2 ein.

Die zweite Darstellung der Fig. 2 zeigt die Erzeugung einer Vertiefung 6 ausgehend von einer umlaufenden Oberfläche 4 in Richtung Zentrum Z des Spendersubstrats 2, wobei die Vertiefung mittels Ablations-LASER-Strahlen 8 eines Ablations-LASERS (nicht gezeigt) erzeugt wird. Bevorzugt verdampfen die Ablations-LASER-Strahlen 8 hierbei zum Erzeugen der Vertiefung 6 das Material des Spendersubstrats 2.

Gemäß Darstellung 3 der Fig. 2 ist die Form der Vertiefung nicht unsymmetrisch, sondern symmetrisch erzeugt. Somit wird ebenfalls gemäß dieser Darstellung eine Spannungserzeugungsschicht 14 an dem Spendersubstrat 2 erzeugt oder angeordnet und zum Erzeugen von mechanischen Spannungen zum Auslösen eines Risses 20 thermisch beaufschlagt, insbesondere mittels flüssigem Stickstoff.

Darstellung 4 der Fig. 2 zeigt die vom Spendersubstrat 2 abgespaltete Festkörperscheibe 1, an der weiterhin die Spannungserzeugungsschicht angeordnet ist.

Der Darstellung 5 der Fig. 2 lässt sich weiter entnehmen, dass bei einem Spendersubstrat 2 dessen Kante 17 bearbeitet ist, die mittels Ablations-LASER-Strahlen 8 zu erzeugende Vertiefung 6 weiter in Richtung Zentrum des Spendersubstrats 2 hineinreichen muss, als wenn die Kante 17 nicht bearbeitet ist. Es ist hierbei jedoch ebenfalls vorstellbar, dass die Vertiefung nicht mittels Ablations-LASER-Strahlen 8, sondern mittels eines Schleifwerkzeugs 22 (wie es z.B. aus der Figur 1 bekannt ist) erzeugt wird.

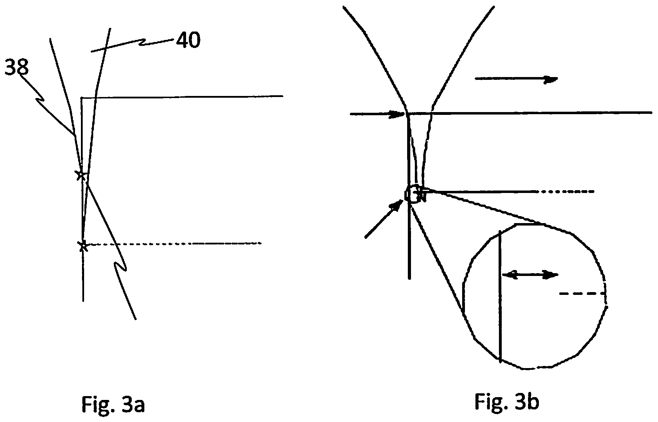

Die Figuren 3a und 3b zeigen ein bei der Erzeugung von Modifikationen mittels LASER-Strahlen 12 auftretendes Problem im Randbereich des Spendersubstrats 2. Durch die unterschiedlichen Brechindizes in der Luft und im Spendersubstrat treffen die LASER-Strahlanteile 38, 40 eines LASER-Strahls 12 nicht genau zusammen, wodurch ungewünschte Effekte, wie die Erzeugung von Defekten an ungewünschten Orten, eine ungewünschte lokale Aufheizung oder ein Verhinderung einer Modifikationserzeugung.

Fig. 3b zeigt, dass eine problemlose Erzeugung von Modifikationen 10 erst erfolgen kann, wenn die zu erzeugende Modifikation 10 soweit von der umlaufenden Oberfläche des Spendersubstrats 2 entfernt ist, dass beide LASER-Strahlanteile 38, 40 jeweils durch Material mit demselben Brechungsindex und bevorzugt über die gleiche Weglänge gebrochen werden. Dies führt jedoch dazu, dass die Modifikationserzeugung, wie sie im zum Randbereich beabstandeten Bereich erfolgt, nicht ohne weiteres auf den Randbereich erstreckt werden kann.

Fig. 4 zeigt eine Anordnung gemäß der ein LASER-Strahl 12 parallel zur Längsachse L ausgerichtet ist. Ferner zeigt diese Darstellung zusätzlich einen LASER-Strahl 60, der in einem Winkel α1 gegenüber der Längsachse L geneigt ist. Beide LASER-Strahlen 12 und 60 dienen hierbei zur Erzeugung der Modifikationen 10, durch die ein Ablösebereich 11 vorgegeben wird. Es ist hierbei denkbar, dass durch den gegenüber der Längsachse L ungeneigten LASER-Strahl 12 eine Mehrzahl der Modifikationen 10 erzeugt wird und im Randbereich, d.h. in einem Abstand von weniger als 10 mm, insbesondere von weniger als 5 mm oder von weniger als 2 mm oder von weniger als 1 mm oder von weniger als 0,5 mm zur umlaufenden Oberfläche (Umfangsoberfläche), die Modifikationen 10 durch den gegenüber der Längsachse L geneigten LASER-Strahl 60 erzeugt werden.

Alternativ ist ferner denkbar, dass alle Modifikationen 10 des Ablösebereichs oder die Mehrzahl der Modifikationen 10 des Ablösebereichs 11 durch den gegenüber der Längsachse L in einem Winkel α1 geneigten LASER-Strahl 60 erzeugt werden.

Zusätzlich oder alternativ können im Sinne der vorliegenden Erfindung die Modifikationen 10 im Randbereich durch einen weiteren gegenüber der Längsachse L des Spendersubstrats 2 geneigten LASER-Strahl 62, 64 erzeugt werden, wobei dieser LASER-Strahl bevorzugt über eine umlaufende Oberfläche des Spendersubstrats 2 in das Spendersubstrat 2 eindringt. Der Darstellung kann entnommen werden, dass ein LASER-Strahl 62 z.B. in einem Winkel α2, der größer als 0° und kleiner als 90° ist, gegenüber dem Ablösebereich 11 über die umlaufende Oberfläche in das Spendersubstrat 2 zur Erzeugung der Modifikationen 10 im Randbereich einleitbar ist. Ferner kann der Darstellung entnommen werden, dass ein LASER-Strahl 64 in der Erstreckungsrichtung des Ablösebereichs 11 über die umlaufende Oberfläche des Spendersubstrats 2 in das Spendersubstrat 2 zum Erzeugen der Modifikationen 10 einleitbar ist. Der LASER-Strahl 64 ist dabei bevorzugt in einem Winkel α3, zwischen 80° und 100°, insbesondere 90° oder im Wesentlichen 90°, gegenüber der Längsachse L des Spendersubstrats 2 geneigt.

Somit kann durch einen der LASER-Strahlen 60, 62, 64 eine Modifikationserzeugung 10 im Bereich des Randes erfolgen.

Weiterhin können erfindungsgemäß die Aussagen zu Fig. 1 analog auf die in Fig. 4 gezeigten Gegenstände angewendet oder übertragen werden.

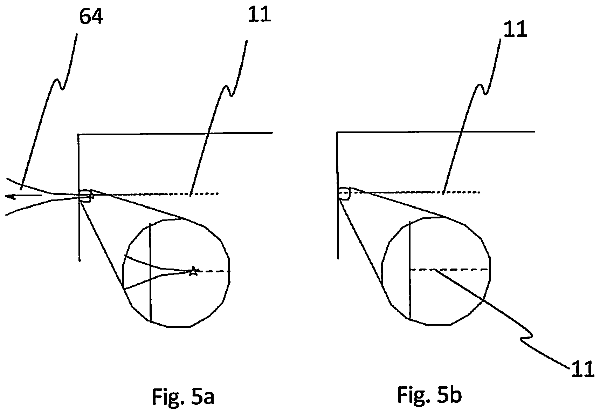

Fig. 5a zeigt einen bis auf den Randbereich erzeugten Ablösebereich 11. Ferner zeigt Fig. 5a die Modifikationserzeugung mittels eines LASER-Strahls 64. Durch den LASER-Strahl 64 werden bevorzugt in radialer Richtung mehrere Modifikationen 10, insbesondere auf einer Linie, mit größer werdenden Abständen zum Zentrum bzw. einer Rotationsachse (die sich bevorzugt orthogonal zur ebenen Oberfläche 16 des Spendersubstrats 2 erstreckt) des Spenderwafers 2 erzeugt.

Fig. 5b zeigt schematisch einen Zustand nach der Erzeugung der Modifikationen 10. Der Ablösebereich 11 ist gemäß dieser Darstellung in Form einer sich vollständig im Inneren des Spenderwafers 2 erstreckenden Modifikationslage ausgebildet.

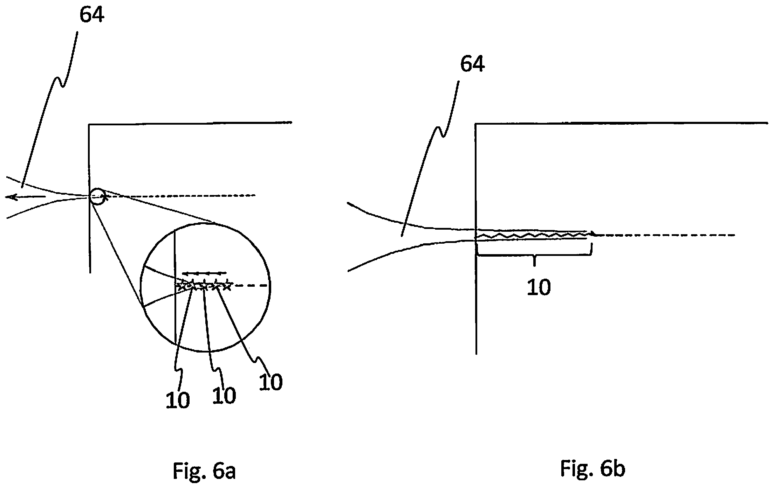

Die Figuren 6a und 6b zeigen zwei Varianten zur Erzeugung von Modifikationen 10 mittels über die umlaufende Oberfläche eingeleiteter LASER-Strahlen.

Gemäß Fig. 6a erfolgt die Erzeugung einer Vielzahl an Modifikationen 10 über dieselbe Eindringstelle, durch die die LASER-Strahlen 64 in das Spendersubstrat 2 eindringen. Die LASER-Strahlen werden zur Erzeugung der Modifikationen 10 auf unterschiedliche Tiefen in radialer Richtung in das Spendersubstrat 2 fokussiert. Bevorzugt werden die Modifikationen 10 mit abnehmender Eindringtiefe der LASER-Strahlen bzw. mit kürzer werdendem Abstand des Fokuspunkts zur Eindringstelle erzeugt.

Fig. 6b zeigt die filamentartige Modifikationserzeugung. Die in Form von Filamenten erzeugten Modifikationen 10 sind dabei länger als ein Vielfaches, insbesondere z.B. das 10 fache, 20 fache oder 50 fache, ihrer Querschnittserstreckung.

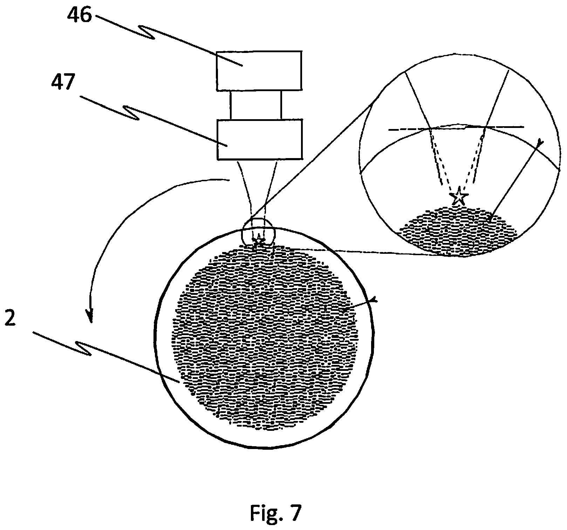

Fig. 7 zeigt eine LASER-Einrichtung 46, ein Aberrationsmittel 47 und eine Schnittdarstellung eines Spendersubstrats 2. Die Detaildarstellung der Fig. 7 zeigt den über die gebogene umlaufende Oberfläche des Spenderwafers 2 in den Spenderwafer 2 eindringenden LASER-Strahl 12, wobei durch die gestrichelt dargestellten Linien der mittels des Aberrationsmittels 47 angepasste Strahlungsverlauf dargestellt ist.

Die vorliegende Erfindung bezieht sich somit auf ein Verfahren zum Abtrennen von Festkörperscheiben 1 von einem Spendersubstrat 2. Das erfindungsgemäße Verfahren umfasst dabei die Schritte: Bereitstellen eines Spendersubstrats 2, Erzeugen von mindestens einer Modifikationen 10 im Inneren des Spendersubstrats 2 mittels mindestens eines LASER-Strahls 12, wobei der LASER-Strahl 12 über eine ebene Oberfläche 16 des Spendersubstrats 2 in das Spendersubstrat 2 eindringt, wobei der LASER-Strahl 12 derart gegenüber der ebenen Oberfläche 16 des Spendersubstrats 2 geneigt ist, dass er in einem Winkel von ungleich 0° oder 180° gegenüber der Längsachse des Spendersubstrates in das Spendersubstrat eindringt, wobei der LASER-Strahl 12 zum Erzeugen der Modifikation 10 im Spendersubstrat 2 fokussiert wird, wobei sich die Festkörperscheibe 1 durch die erzeugten Modifikationen 10 von dem Spendersubstrat 2 ablöst oder eine Spannungserzeugungsschicht 14 an der ebenen Oberfläche 16 des Spendersubstrats 2 erzeugt oder angeordnet wird und durch ein thermisches Beaufschlagen der Spannungserzeugungsschicht 14 mechanische Spannungen in dem Spendersubstrat 2 erzeugt werden, wobei durch die mechanischen Spannungen ein Riss 20 zum Abtrennen einer Festkörperschicht 1 entsteht, der sich entlang der Modifikationen 10 ausbreitet.

Fig. 8 zeigt schematisch eine Anordnung, gemäß der die Spannungserzeugungsschicht 14 bevorzugt mindestens eine Vertiefung 6, insbesondere Ausnehmung oder Graben, die sich bevorzugt ausgehend von einer ebenen bzw. im Wesentlichen ebenen Oberfläche 16 in Richtung einer zur ebenen Oberfläche 16 bevorzugt parallelen weiteren Oberfläche des Festkörpers 2 hin erstreckt, überlagert bzw. überdeckt bzw. verschließt.

Die Spannungserzeugungsschicht 14 wird bevorzugt als Polymerschicht erzeugt bzw. wird als Schicht erzeugt, die zu überwiegenden Massen- und/oder Volumenanteilen aus mindestens einem Polymermaterial besteht. Die Oberfläche 16, an der die Spannungserzeugungsschicht 14 angeordnet wird, weist bevorzugt behandelte Anteile auf. Als behandelte Anteile werden hierbei bevorzugt Anteile verstanden, in denen Material abgetragen wurde. Bevorzugt erstrecken sich somit ausgehende von der Oberfläche 16, an der die Spannungserzeugungsschicht 14 angeordnet wird und die sich bevorzugt im Wesentlichen oder vollständig parallel zu einer aus Modifikationen 10 gebildeten Rissführungsschicht erstreckt, Vertiefung/en, insbesondere Ausnehmungen 6 und/oder Gräben 6, bevorzugt orthogonal zur Oberfläche und/oder zur Rissführungsschicht. Es ist hierbei alternativ denkbar, dass nur eine Vertiefung 6, insbesondere ein Graben und/oder eine Ausnehmung, mittels Materialabtrag erzeugt wurde und/oder ausgebildet ist. Der Materialabtrag wird bevorzugt vor der Erzeugung oder Anbringung der Spannungserzeugungsschicht 14 an der Oberfläche 16 bewirkt, insbesondere mittels Laserablation. Die Spannungserzeugungsschicht 14 überdeckt im mit dem Festkörper 2 gekoppelten bzw. verbundenen Zustand die Vertiefung/en 6, Insbesondere den Graben bzw. die Gräben oder die Ausnehmung bzw. die Ausnehmungen.

Bevorzugt erfolgt zwischen der Erzeugung der Vertiefung 6, insbesondere der Ausnehmung und/oder des Grabens, und der Anbringung der Spannungserzeugungsschicht keine weitere Beschichtung, insbesondere kein weiterer Materialauftrag. Dies ist vorteilhaft, da sich sonst Material in der Ausnehmung/Graben ansammeln könnte.

Bevorzugt erfolgt die Anbringung der Spannungserzeugungsschicht mittels eines Plasma-Laminationsprozesses. Dies ist vorteilhaft, das so über die Vertiefung 6, insbesondere Ausnehmung/Graben, hinweg eine Verbindung zwischen dem Festkörper 1, insbesondere der Hauptoberfläche 16 der späteren Festkörperschicht 1, und der Spannungserzeugungsschicht 14 erzeugt werden kann. Die Verbindung stellt bevorzugt ein Laminieren oder Kleben dar. Bevorzugt wird dies unter Verwendung von Kaltplasma umgesetzt.

Zusätzlich oder alternativ kann erfindungsgemäß ein "Spontansplit" mit zuvor erzeugter Laserebene bzw. Rissführungsebene und Tiefenmodifikation durch einen Materialabtragungsschritt, insbesondere Laserablation, bewirkt werden. Bevorzugt wird dies ohne Spannungserzeugungsschicht 14 bewirkt.

Die Spannungserzeugungsschicht 14 kann auch als Stressorschicht, insbesondere als selbsttragende Stressorschicht, bezeichnet werden.

Erfindungsgemäß wurde ferner erkannt, dass eine selbsttragende Stressorschicht gegenüber einer aufgedampften oder anderweitig durch Abscheidung aufgebrachten Stressorschicht von entscheidendem technischem Vorteil ist, da solche Stressorschichten zum einen in größerem Volumen in einfacheren Verfahren in spezialisierten Anlagen mit höherem Durchsatz hergestellt werden können und zum anderen in Laminationsprozessen eingesetzt werden können, die ebenfalls höhere Prozessgeschwindigkeiten erlauben. Zusätzlich können selbsttragende Stressorschichten nach Laminationsprozessen auch unter geringem Aufwand wieder vom Substrat abgelöst werden, was zum Beispiel auch eine Wiederverwendung, d.h. der Stressorschicht bzw. der Spannungserzeugungsschicht, erlaubt, die mit abgeschiedenen Schichten unmöglich ist.

Besonders vorteilhaft ist, dass Laminationsprozesse auch ohne Klebeverfahren oder ähnliches rein durch eine Oberflächenaktivierung, Oberflächenbehandlung oder Oberflächenmodifikation des Substrates realisiert werden können. Somit erfolgt eine Kopplung bzw. Verbindung der Spannungserzeugungsschicht mit dem Festkörper, insbesondere mit der Oberfläche 16 der späteren Festkörperschicht 1, besonders bevorzugt durch eine Oberflächenaktivierung und/oder Oberflächenbehandlung und/oder Oberflächenmodifikation des Festkörpers bzw. der Oberfläche 16 der späteren Festkörperschicht 1.

So kann die Oberfläche z.B. bevorzugt durch Kontakt mit, insbesondere in einer Kammer, erzeugtem Ozon und/oder durch ultraviolettes Licht einer bestimmten Wellenlänge und/oder durch Plasmaverfahren mit unterschiedlichen gebildeten Spezies an den Oberflächen des Substrats und/oder der Stressorschicht und/oder im Prozessgas, insbesondere radikalische, Aldehyd-, und Alkohol-Spezies, aktiviert werden. Hier werden insbesondere Heißplasma-Verfahren bevorzugt, bei denen hohe Temperaturen Anwendung finden, um freie Ladungsträger und Radikale im Plasma zu erzeugen, was für die daraus folgenden Reaktionen an den Oberflächen von Substrat und Stressorschicht andere Reaktionspfade und chemische Oberflächenreaktionen erlaubt als bei niedrigeren Temperaturen. Der Oberflächenmodifikationsmechanismus kann sich also temperaturabhängig unterscheiden, ebenso zwischen verschiedenen Substraten, wobei z.B. bei SiC im Gegensatz zu Si, die beteiligten Kohlenstoffatome andere Oberflächenspezies in der Plasmabehandlung ausbilden können, die im Laminationsprozess ebenfalls haftvermittelnd wirken können.

Alternativ ist der Einsatz eines Kaltplasma-Verfahrens möglich, bei dem ein Plasma nicht durch Glühemission und über heiße Wolfram-Filamente oder ähnliche Methoden erzeugt wird, sondern über piezoelektrische Transformatoren bei atmosphärischem Druck und bevorzugt ohne erhöhte Temperaturen. Diese niedrigeren Temperaturen vermindern und/oder verändern ebenfalls die zur Verfügung stehenden Reaktionspfade für Oberflächenaktivierungen und Oberflächenmodifikationen zur Haftvermittlung in Laminationsprozessen, sowohl am Substrat bzw. dem Festkörper als auch an der Stressorschicht. Die entstandenen Oberflächenspezies hängen also von einer Vielzahl von Parametern und der Oberflächenaktivierungsmethode im Besonderen ab.

Die Oberflächenbehandlung bzw. -modifikation umfasst beispielsweise die zumindest abschnittsweise Beaufschlagung der zu behandelnden Oberfläche durch eine Koronabehandlung und/oder durch eine Flammbehandlung und/oder durch eine Behanldung mittels elektrischer Barriereentladung und/oder durch Fluorierung und/oder durch Ozonierung und/oder durch Eximerbestahlung und/oder durch eine Behandlung mit einem Plasma, wobei bevorzugt einzelne oder mehrere physikalische Parameter, wie die Art des Plasmas, der Spurabstand bei der Plasmabehandlung, die Düsenart, der Düsenabstand und/oder die Dauer der Plasmabehandlung, variiert werden bzw. variierbar sind.

Bevorzugt wird eine Plasmavorbehandlung bzw. Plasmabehandlung sowohl zu einer Reinigung als auch anschließend zu einer Homogenisierung der Oberflächenspezies herangezogen (z.B. Hydrophobierung u.a.).

Mittels einer gezielten individuellen Plasmabehandlung ist eine ortsaufgelöste Variation der Oberflächenaktivierung erzeugbar bzw. einstellbar, die anschließend eine Lamination der Stressorschicht erlaubt - ebenfalls mit ortsveränderlichen Eigenschaften, wenn gewünscht.

Der Prozess der Plasmaoberflächenaktivierung bzw. der Plasmaoberflächenbehandlung gestattet eine größere Einflussnahme, um die gewünschte differenzierte Haftung bzw. Kraftübertragung nach der Lamination der Stressorschicht auf dem Substrat auch auf großen Flächen in einer definierten symmetrischen oder aber asymmetrischen Form aufzubringen. Hierbei kann durch Prozessvariation gezielt, insbesondere lokal, eine geänderte Adhäsion oder Kohäsion eingestellt werden. In Abhängigkeit der Ausgangseigenschaften der unterschiedlichen Festkörpermaterialien, insbesondere Halbleitermaterialien, können Schichten aufgebracht und/oder durch weitere graduelle Prozessgase (Sauerstoff, u.a.) die gewünschten Zusatzschicht/en, insbesondere Opfer/Schadschichten oder Substrat- und/oder Stressorschicht-Oberflächen, gezielt modifiziert werden (hydrophob, hydrophil, Benetzung etc.). Dies führt
zu einer ortaufgelösten angepassten graduellen Haftung bzw. ortaufgelöst angepassten oder eingestellten Kraftübertragungsverbindung, auch in Laminationsprozessen, was gegenüber der durch Klebe- und Abscheidelösungen für die Stressorschicht nur homogen und nicht ortsaufgelöst.

Wie bereits beschrieben können unterschiedliche physikalische Parameter während der Plasmabehandlung zum Einsatz kommen (z.B. Art des Plasmas, Spurabstand bei der Plasmabehandlung, Düsenart, Düsenabstand, Dauer der Plasmabehandlung). Zusätzlich zu diesen Einflussparametern kann durch eine gezielte Beimischung von graduellen Prozessgasen wie z.B. Stickstoff, Sauerstoff, Wasserstoff, SiH4, Si(EtO)4 oder Me3SiOSiMe3 (u.a.) eine größere Bandbreite der notwendigen Oberflächeneigenschaften herbeigeführt werden. Diese resultieren bevorzugt aus neuen chemischen Oberflächenspezies, die sich auf der Halbleiteroberfläche und/oder den sich anschließenden Opferschichten und/oder der Stressorschicht abscheiden und so eine unterschiedlich ausgebildete Oberflächenfunktionalität und Laminationsprozesseigenschaften ermöglichen. Dies führt zu den gewünschten Zielprofilen, wie zum Beispiel unterschiedliche ortsaufgelöste Adhäsions- und Kohäsionseigenschaften, der Halbleiteroberflächen und/oder den sich anschließenden Stressor- und/oder anderen Schichten.

Eine Korona-Behandlung ist ein elektrochemisches Verfahren zur Oberflächenbehandlung bzw. -modifikation von Kunststoffen. Hierbei wird die Oberfläche einer elektrischen Hochspannungs-Entladung ausgesetzt. Eine Koronabehandlung wird z.B. zur Haftvermittlung bei Kunststoffen, Folien u.a. (PE, PP) verwendet.

Bei einer Flammenbehandlung kommt vor allem eine oberflächennahe Oxidation der jeweiligen Verbindungen zum Tragen. Im Wesentlichen erfolgen Oxidationsprozesse, durch die je nach Material und Versuchsbedingungen verschiedene polare funktionelle Gruppen gebildet werden (z.B. Oxide, Alkohole, Aldehyde, Carbonsäuren, Ester, Ether, Peroxide).

Eine Behandlung durch dielektrische Barriereentladung (DBE, Wechselspannungs-Gasentladung, dieelectric barrier discharge, auch DBD Behandlung) ist einem Niedertemperaturplasma bzw. einer Glimmentladung (z.B. GDMS) ähnlich. Bei der DBE-Behandlung wird die Oberfläche mit uni- oder bipolaren Pulsen mit Pulsdauern von wenigen Mikrosekunden bis hinunter zu einigen zehn Nanosekunden und Amplituden im einstelligen Kilovoltbereich beaufschlagt. Eine dielektrische Barriereentladung ist vorteilhaft, da hierbei keine metallischen Elektroden im Entladungsraum und somit keine metallischen Verunreinigungen oder Elektrodenverschleiß zu erwarten sind.

Weitere Vorteile der dielektrische Barriereentladung können je nach Anwendung z.B. sein, dass sie eine hohe Effizienz aufweist, da an den Elektroden keine Ladungsträger aus- oder eintreten müssen (Wegfall des Kathodenfalls, keine Glühemission nötig) oder dass die dielektrischen Oberflächen bei niedrigen Temperaturen modifiziert und chemisch aktiviert werden können. Die Oberflächenmodifikation erfolgt dabei bevorzugt durch eine Wechselwirkung und Reaktion der Oberflächenspezies durch ein Ionenbombardement und der Einwirkung der Ultraviolettstrahlung auf die Oberflächenspezies (z.B. 80nm - 350nm, inkohärentes Licht UV und VUV, durch Leistungs-Hochfrequenzgeneratoren). Die dielektrische Barriereentladung findet z.B. Anwendung zur in situ Herstellung von Ozon in der Trink- / Abwasseraufbereitung, wobei durch das Ozon eine Ozonierung des Wassers erfolgt. Analog hierzu erfolgt bei einer erfindungsgemäßen Oberflächenbehandlung oder - modifikation mittels Ozonierung eine Beaufschlagung der zu behandelnden Oberfläche mittels Ozon.

Eine Oberflächenbehandlung bzw. -modifikation mittels Halogenierung, insbesondere Fluorierung, bewirkt die Überführung eines Elementes oder einer Verbindung in ein Halogenid. Durch die Fluorierung erfolgt somit die Einführung von Fluor in bevorzugt organische Verbindungen mit Hilfe von Fluorierungsmitteln.

Eine Oberflächenbehandlung bzw. -modifikation mittels einer UV-Behandlung erfolgt bevorzugt durch eine Eximer Bestrahlung oder durch ultraviolette Leuchtdiodenquellen, z.B. auf Aluminiumnitrid-Basis. Eine Eximerbestrahlung erfolgt durch die Verwendung von mindestens einem Excimerlaser. Eximerlaser sind Gaslaser, die elektromagnetische Strahlung im ultravioletten Wellenlängenbereich erzeugen können. Eine hierbei erfolgende Gasentladung wird somit durch ein elektromagnetisches Hochfrequenzfeld hervorgerufen. Deshalb werden auch keine Elektroden bei der Gasentladung benötigt. Die erzeugte UV.Strahlung, liegt bevorzugt in einem Wellenlängenbereich zwischen 120 nm und 380 nm.

**Bezugszeichenliste**

| | | | |
|---|---|---|---|
| 1 | Festkörperscheibe | 20 | Riss |
| 2 | Spendersubstrat | 22 | Schleifwerkzeug |
| 4 | in Umfangsrichtung erstreckende Oberfläche | 24 | erster Bearbeitungsanteil |
| | | 26 | zweiter Bearbeitungsanteil |
| 6 | Vertiefung | 28 | Unterseite |
| 8 | Ablations-LASER-Strahlen | 30 | Oberseite |
| 10 | Modifikationen | 32 | Hauptschleiffläche |
| 12 | weitere LASER-Strahlen | 34 | Nebenschleiffläche |
| 14 | Spannungserzeugungsschicht | 36 | erster Anteil an LASER-Strahlen |
| 16 | ebene Oberfläche | 38 | erster Winkel |
| 17 | Kante | 40 | weiterer Anteil |
| 18 | Vertiefungsende | 42 | zweiter Winkel |
| 44 | Rand | 48 | LASER-Fokus |
| 46 | LASER-Einrichtung | | |

## Patentansprüche

1. Verfahren zum Abtrennen von Festkörperlagen, insbesondere Festkörperscheiben (1), von einem Spendersubstrat (2), mindestens umfassend die Schritte:
Bereitstellen eines Spendersubstrats (2),
Erzeugen von mindestens einer Modifikationen (10) im Inneren des Spendersubstrats (2) mittels mindestens eines LASER-Strahls (12), wobei der LASER-Strahl (12) über eine ebene Oberfläche (16) des Spendersubstrats (2) in das Spendersubstrat (2) eindringt, wobei die Oberfläche (16) vollständig Bestandteil der abzutrennenden Festkörperscheibe (1) ist,
**dadurch gekennzeichnet, dass**
der LASER-Strahl (12) derart gegenüber der ebenen Oberfläche (16) des Spendersubstrats (2) geneigt ist, dass er in einem Winkel von ungleich 0° oder 180° gegenüber der Längsachse des Spendersubstrates in das Spendersubstrat eindringt, wobei der LASER-Strahl (12) zum Erzeugen der Modifikation (10) im Spendersubstrat (2) fokussiert wird,
wobei ein erster Anteil (36) des LASER-Strahls (12) in einem ersten Winkel (38) zur ebenen Oberfläche (16) des Spendersubstrats (2) in das Spendersubstrat (2) eindringt und mindestens ein weiterer Anteil (40) des LASER-Strahls (12) in einem zweiten Winkel (42) zur ebenen Oberfläche (16) des Spendersubstrats (2) in das Spendersubstrat (2) eindringt, wobei sich der Betrag des ersten Winkels (38) von dem Betrag des zweiten Winkels (42) unterscheidet, wobei der erste Anteil (36) des LASER-Strahls (12) und der weitere Anteil (40) des LASER-Strahls (12) zum Erzeugen der Modifikation (10) im Spendersubstrat (2) fokussiert werden
wobei sich die Festkörperscheibe (1) durch die erzeugten Modifikationen (10) von dem Spendersubstrat (2) ablöst
oder
eine Spannungserzeugungsschicht (14) an der ebenen Oberfläche (16) des Spendersubstrats (2) erzeugt oder angeordnet wird und durch ein thermisches Beaufschlagen der Spannungserzeugungsschicht (14) mechanische Spannungen in dem Spendersubstrat (2) erzeugt werden, wobei durch die mechanischen Spannungen ein Riss (20) zum Abtrennen einer Festkörperschicht (1) entsteht, der sich entlang der Modifikationen (10) ausbreitet.

2. Verfahren nach Anspruch 1,
**dadurch gekennzeichnet, dass**
die Gesamtheit der LASER-Strahlen (12) für die Erzeugung von Modifikationen (10) im Bereich des Zentrums (Z) des Spendersubstrats (2) und für die Erzeugung von Modifikationen (10) im Bereich eines sich in radialer Richtung ergebenden Rands (44), insbesondere in einem Abstand von weniger als 10 mm und bevorzugt von weniger als 5 mm und besonders bevorzugt von weniger als 1 mm zum Rand, des Spendersubstrats (2) in derselben Ausrichtung gegenüber der ebenen Oberfläche (16) des Spendersubstrats (2) ausgerichtet ist.

3. Verfahren nach Anspruch 1 oder 2,
**dadurch gekennzeichnet, dass**
der erste Anteil (36) der LASER-Strahlen (12) in einem ersten Winkel (38) zur ebenen Oberfläche (16) des Spendersubstrats (2) in das Spendersubstrat (2) eindringt und der weitere Anteil (40) der LASER-Strahlen (12) in einem zweiten Winkel (42) für die Erzeugung von Modifikationen (10) im Bereich des Zentrums (Z) des Spendersubstrats (2) und für die Erzeugung von Modifikationen (10) im Bereich eines sich in radialer Richtung ergebenden Rands (44) des Spendersubstrats (2) eindringt, wobei sich der Betrag des ersten Winkels (38) von dem Betrag des zweiten Winkels (42) stets unterscheidet.

4. Verfahren nach einem der vorangegangenen Ansprüche 1 bis 3,
**dadurch gekennzeichnet, dass**
wobei die LASER-Strahlen (12) von einer LASER-Einrichtung (46) emittiert werden,
wobei die LASER-Einrichtung (46) ein Picosekundenlaser oder ein Femtosekundenlaser ist
und/oder
die Energie der LASER-Strahlen (12), insbesondere des fs-LASER, derart gewählt wird, dass die Schädigungsausbreitung einer jeden Modifikation (10) in dem Spendersubstrat (2) kleiner als 3 mal die Rayleighlänge, bevorzugt kleiner als die Rayleighlänge und besonders bevorzugt kleiner ein Drittel mal die Rayleighlänge ist
und/oder
die Wellenlänge der LASER-Strahlen (12), insbesondere des fs-LASER, derart gewählt wird, dass die Absorption des Spendersubstrats (2) kleiner als 10cm⁻¹ und bevorzugt kleiner als 1cm⁻¹ und besonders bevorzugt kleiner als 0,1cm⁻¹ ist
und/oder
sich die einzelnen Modifikationen (10) jeweils in Folge einer von den LASER-Strahlen (12), insbesondere des fs-LASER, bewirkten multi-photonen Anregung ergeben.

5. Verfahren nach einem der vorangegangenen Ansprüche,
**dadurch gekennzeichnet, dass**
der LASER-Strahl (12) über eine umlaufende Oberfläche des Spendersubstrats (2), insbesondere in radialer Richtung des Spendersubstrats (2), in das Spendersubstrat (2) eindringt.

6. Verfahren nach Anspruch 5,
**dadurch gekennzeichnet, dass**
die über die umlaufende Oberfläche in das Spendersubstrat (2) eingeleiteten LASER-Strahlen (12) Modifikationen (10) erzeugen, die länglich, insbesondere filamentartig, ausgebildet sind,
und/oder
die an einer Position der umlaufenden Oberfläche des Spendersubstrats (2) eingeleiteten LASER-Strahlen (12) zur Erzeugung mehrerer Modifikationen (10) auf unterschiedliche Eindringtiefen fokussiert wird, wobei die Modifikationen (10) dabei bevorzugt ausgehend von der tiefsten Tiefe hin zur geringsten Tiefe erzeugt werden.

7. Verfahren nach einem der Ansprüche 5 oder 6,
**dadurch gekennzeichnet, dass**
ein Mittel zur Aberrationsanpassung vorgesehen ist und durch das Mittel eine Aberrationsanpassung bei den über die umlaufende Oberfläche eindringenden LASER-Strahlen bewirkt wird.

8. Verfahren nach einem der vorangegangenen Ansprüche,
**dadurch gekennzeichnet, dass**
die Spannungserzeugungsschicht (14) ein Polymer, insbesondere Polydimethylsiloxan (PDMS), aufweist oder daraus besteht, wobei die thermische Beaufschlagung derart erfolgt, dass das Polymer einen Glasübergang erfährt, wobei die Spannungserzeugungsschicht (14), insbesondere mittels flüssigem Stickstoff, auf eine Temperatur unterhalb der Raumtemperatur oder unterhalb von 0°C oder unterhalb von -50°C oder unterhalb von - 100°C oder unterhalb von -110°C, insbesondere auf eine Temperatur unterhalb der Glasübergangstemperatur der Spannungserzeugungsschicht (14), temperiert wird.

## Claims

1. Method for separating solid-state layers, in particular solid-state wafers (1), from a donor substrate (2),
at least comprising the following steps:
providing a donor substrate (2),
producing at least one modifications (10) in the interior of the donor substrate (2) by means of at least one LASER beam (12), wherein the LASER beam (12) penetrates into the donor substrate (2) via a planer surface (16) of the donor substrate (2), wherein the surface (16) is completely part of the solid-state wafer (1) to be separated,
**characterized in that** the LASER beam (12) is inclined relative to the planer surface (16) of the donor substrate (2) in such a way that it penetrates into the donor substrate at an angle of not equal to 0° or 180° relative to a longitudinal axis of the donor substrate, wherein the LASER beam (12) is focused for the purpose of producing the modification (10) in the donor substrate (2),
wherein a first portion (36) of the LASER beam (12) penetrates into the donor substrate (2) at a first angle (38) with respect to the planer surface (16) of the donor substrate (2) and at least one further portion (40) of the LASER beam (12) penetrates into the donor substrate (2) at a second angle (42) with respect to the planer surface (16) of the donor substrate (2), wherein the absolute value of the first angle (38) differs from the absolute value of the second angle (42), wherein the first portion (36) of the LASER beam (12) and the further portion (40) of the LASER beam (12) are focused for the purpose of producing the modification (10) in the donor substrate (2),
wherein the solid-state wafer (1) detaches from the donor substrate (2) as a result of the modifications (10) produced,
or
a stress-inducing layer (14) is produced or arranged at the planer surface (16) of the donor substrate (2) and mechanical stresses are induced in the donor substrate (2) by means of thermal exposure of the stress-inducing layer (14), wherein the mechanical stresses give rise to a crack (20) for separating a solid-state layer (1), which crack propagates along the modifications (10).

2. Method according to Claim 1,
**characterized in that**
the totality of the LASER beams (12) for producing modifications (10) in the region of the centre (Z) of the donor substrate (2) and for producing modifications (10) in the region of an edge (44) arising in a radial direction, in particular at a distance of less than 10 mm and preferably of less than 5 mm and particularly preferably of less than 1 mm from the edge, of the donor substrate (2) are oriented in the same orientation relative to the planer surface (16) of the donor substrate (2).

3. Method according to Claim 1 or 2,
**characterized in that**
the first portion (36) of the LASER beams (12) penetrates into the donor substrate (2) at a first angle (38) with respect to the planer surface (16) of the donor substrate (2) and the further portion (40) of the LASER beams (12) penetrates at a second angle (42) for producing modifications (10) in the region of the centre (Z) of the donor substrate (2) and for producing modifications (10) in the region of an edge (44) of the donor substrate (2) arising in a radial direction, wherein the absolute value of the first angle (38) always differs from the absolute value of the second angle (42).

4. Method according to any of the preceding Claims 1 to 3,
**characterized in that**
wherein the LASER beams (12) are emitted by a LASER device (46),
wherein the LASER device (46) is a picosecond laser or a femtosecond laser
and/or
the energy of the LASER beams (12), in particular of the fs LASER, is chosen in such a way that the damage propagation of each modification (10) in the donor substrate (2) is less than three times the Rayleigh length, preferably less than the Rayleigh length and particularly preferably less than one third of the Rayleigh length,
and/or
the wavelength of the LASER beams (12), in particular of the fs LASER, is chosen in such a way that the absorption of the donor substrate (2) is less than 10 cm⁻¹ and preferably less than 1 cm⁻¹ and particularly preferably less than 0.1 cm⁻¹,
and/or
the individual modifications (10) arise in each case on account of a multi-photon excitation effected by the LASER beams (12), in particular of the fs LASER.

5. Method according to any of the preceding claims,
**characterized in that**
the LASER beam (12) penetrates into the donor substrate (2) via a circumferential surface of the donor substrate (2), in particular in a radial direction of the donor substrate (2).

6. Method according to Claim 5,
**characterized in that**
the LASER beams (12) introduced into the donor substrate (2) via the circumferential surface produce modifications (10) which are embodied in an elongate fashion, in particular in a filamentlike fashion, and/or
the LASER beams (12) introduced at a position of the circumferential surface of the donor substrate (2) is focused for the purpose of producing a plurality of modifications (10) at different penetration depths, wherein the modifications (10) are in this case preferably produced proceeding from the deepest depth towards the smallest depth.

7. Method according to either of Claims 5 and 6,
**characterized in that**
a means for aberration adaptation is provided and the means brings about an aberration adaptation in the case of the LASER beams penetrating via the circumferential surface.

8. Method according to any of the preceding claims,
**characterized in that**
the stress-inducing layer (14) comprises or consists of a polymer, in particular polydimethylsiloxane (PDMS), wherein the thermal exposure is effected in such a way that the polymer experiences a glass transition, wherein the stress-inducing layer (14) is temperature-regulated, in particular by means of liquid nitrogen, to a temperature below room temperature or below 0°C or below -50°C or below -100 °C or below -110°C, in particular to a temperature below the glass transition temperature of the stress-inducing layer (14).

## Revendications

1. Procédé de séparation de couches semi-conductrices, notamment de tranches (1) semi-conductrices d'un substrat (2) dispensateur,
comprenant au moins les stades :
on se procure un substrat (2) dispensateur,
on produit au moins une modification (10) au sein du substrat (2) dispensateur, au moyen d'au moins un faisceau (12) laser, le faisceau (12) laser pénétrant dans le substrat (2) dispensateur par une surface (16) plane du substrat (2) dispensateur, la surface (16) plane faisant complètement partie de la tranche (1) semi-conductrice à séparer,
**caractérisé en ce que**
le faisceau (12) laser est incliné par rapport à la surface (16) plane du substrat (2) dispensateur, de manière à pénétrer dans le substrat dispensateur en faisant, avec l'axe longitudinal du substrat dispensateur, un angle différent de 0° ou de 180°, le faisceau (12) laser étant focalisé pour produire la modification (10) dans le substrat (2) dispensateur,
dans lequel une première proportion (36) du faisceau (12) laser pénètre dans le substrat (2) dispensateur, en faisant un premier angle (38) avec la surface (16) plane du substrat (2) dispensateur, et au moins une autre proportion (40) du faisceau (12) laser pénètre dans le substrat (2) dispensateur, en faisant un deuxième angle (42) avec la surface (16) plane du substrat (2) dispensateur, la valeur du premier angle (38) étant différente de la valeur du deuxième angle (42), la première proportion (36) du faisceau (12) laser et l'autre proportion (40) du faisceau (12) laser étant focalisées pour produire la modification dans le substrat (2) dispensateur,
dans lequel la tranche (1) semi-conductrice se détache du substrat (2) dispensateur par les modifications (10) produites,
ou
on produit ou on met une couche (14) de production de tension sur la surface (16) plane du substrat (2) dispensateur et, par un traitement thermique de la couche (14) de production de la tension, on produit des tensions mécaniques dans le substrat (2) dispensateur, une fissure (20) de séparation d'une tranche (1) semi-conductrice, qui se propage le long des modifications (10), étant créée par les tensions mécaniques.

2. Procédé suivant la revendication 1,
**caractérisé en ce que**
l'ensemble des faisceaux (12) laser est, pour produire des modifications (10) dans la partie du centre (Z) du substrat (2) dispensateur et pour produire des modifications (10) dans la partie d'un bord (44) s'étendant dans la direction radiale, notamment une distance de moins de 10 mm et de préférence de moins de 5 mm et d'un manière particulièrement préférée de moins de 1 mm du bord du substrat (2) dispensateur, orienté dans la même orientation par rapport à la surface (16) plane du substrat (2) dispensateur.

3. Procédé suivant la revendication 1 ou 2,
**caractérisé en ce que**
la première proportion (36) des faisceaux (12) laser pénètre dans le substrat (2) dispensateur, en faisant un premier angle (38) avec la surface (16) plane du substrat (2) dispensateur, et l'autre proportion des faisceaux (12) laser pénètre, suivant un deuxième angle (42) pour la production de modifications (10) dans la partie du centre (Z) du substrat (2) dispensateur et pour la production de modifications (10) dans la partie d'un bord (44) se produisant dans la direction radiale du substrat (2) dispensateur, la valeur du premier angle (38) étant toujours différente de la valeurs du deuxième angle (42).

4. Procédé suivant l'une des revendications 1 à 3 précédentes,
**caractérisé en ce que**
on émet les faisceaux (12) laser par un dispositif (46) laser, le dispositif (46) laser étant un laser à picoseconde ou un laser à femtoseconde
et/ou
on choisit l'énergie des faisceaux (12) laser, notamment du laser fs, de manière à ce que la propagation du dommage de chaque modification (10) dans le substrat (2) dispensateur soit plus petite que trois fois la longueur de Rayleigh, de préférence plus petite que la longueur de Rayleigh et, d'une manière particulièrement préférée, plus petite qu'un tiers de la longueur de Rayleigh
et/ou
on choisit la longueur d'onde des faisceaux (12) laser, notamment du laser fs, de manière à ce que l'absorption du substrat (2) dispensateur soit plus petite que 10cm⁻¹ et de préférence plus petite que 1cm⁻¹ et, d'une manière particulièrement préférée, plus petite que 0,1cm⁻¹
et/ou
les diverses modifications (10) se produisent chacune en fonction d'une excitation à photons multiples provoquée par les faisceaux (12) laser, notamment du laser fs.

5. Procédé suivant l'une des revendications précédentes,
**caractérisé en ce que**
le faisceau (12) laser pénètre dans le substrat (2) dispensateur par une surface faisant le tour du substrat (2) dispensateur, notamment dans la direction radiale du substrat (2) dispensateur.

6. Procédé suivant la revendication 5,
**caractérisé en ce que**
les faisceaux (12) laser, envoyés dans le substrat (2) dispensateur par la surface faisant le tour, produisent des modifications (10), qui sont oblongues, en étant notamment de type à filament
et/ou
on focalise le faisceau (12) laser, envoyé sur une position de la surface faisant le tour du substrat (2) dispensateur, pour produire plusieurs modifications (10) à des profondeurs de pénétration différentes, les modifications (10) étant produites de préférence en allant de la profondeur la plus grande à la profondeur la plus petite.

7. Procédé suivant l'une des revendications 5 ou 6,
**caractérisé en ce qu'**
il est prévu un moyen d'adaptation aux aberrations et on provoque par le moyen une adaptation aux aberrations des faisceaux laser pénétrant par la surface faisant le tour.

8. Procédé suivant l'une des revendications précédentes,
**caractérisé en ce que**
la couche (14) de production d'une tension a un polymère, notamment du polydiméthylsiloxane (PDMS) ou en est constituée, le traitement thermique s'effectuant de manière à ce que le polymère subisse une transition vitreuse, la couche (14) de production d'une tension étant, notamment au moyen d'azote liquide, mise à une température inférieure à la température ambiante ou inférieure à 0°C ou inférieure à -50°C ou inférieure à -100°C ou inférieure à -110°C, notamment à une température inférieure au point de transition à l'état vitreux de la couche (14) de production d'une tension.
